# EUROPEAN PATENT APPLICATION

(11) **EP 1 903 375 A1**
(43) Date of publication of application: **26.03.2008**
(21) Application number: 07252455.6
(22) Date of filing: 15.06.2007
(51) Int. Cl.: G02F 1/13

(54) **Organic light emitting display**

(30) Priority: 20.09.2006 KR 20060091231
(71) Applicant: Samsung SDI Co., Ltd., Suwon-si, Gyeonggi-do (KR)
(72) Inventor: Wang, Chan Hee, Gyeonggi-do (KR); Oh, Yoon Chan, Gyeonggi-do (KR); Lim, Dae-Ho, Gyeonggi-do (KR)
(74) Representative: Mounteney, Simon James

(57) **Abstract**

Disclosed is an organic light emitting display device in which a display panel (100) is accommodated in a support frame (300). The organic light emitting display device includes the display panel, the support frame and an intervening frame (200). The display panel includes a first substrate (110) in which an organic light emitting device is formed, a second substrate (120) opposing the first substrate, and an encapsulation material (130) formed between the first substrate and the second substrate. The support frame includes a lower surface (310) and a plurality of side walls (320,330,340) extending from the edges of the lower surface. The lower surface and the side walls define a space in which the display panel is accommodated. The intervening frame is interposed between the side walls of the support frame and the display panel.

## Description

### 1. Field of the Invention

The present invention relates to an organic light emitting display device, and more particularly, to an organic light emitting display in which a display panel is accommodated in a frame.

### 2. Discussion of Related Art

In general, a display panel of an organic light emitting display device includes a substrate in which an array of light emitting pixels is formed and a container or a substrate for encapsulating the array.

The array is connected between a plurality of scan lines and a plurality of data lines in the form of a matrix and includes a plurality of pixels having an anode electrode, a cathode electrode, and an organic thin film layer. If a predetermined voltage is applied to the anode electrode and the cathode electrode, a hole injected through the anode electrode and an electron injected through the cathode electrode are recombined on a light emitting layer, and light is emitted by energy difference generated in the process.

In the display panel of the organic light emitting display device, since the substrate is generally formed of glass, it may be vulnerable to an impact. Therefore, the display panel is mounted to a bezel formed of a metal to be supported and protected. However, since as the size and thickness of a small-sized portable device such as a mobile phone gradually decreases, the reduction of the thickness of the display panel or substrate is desired, which may cause an increase of fragility.

The discussion in this section is to provide general background information, and does not constitute an admission of prior art.

### SUMMARY

According to a first aspect of the invention there is provided an organic light emitting display device as set out in claim 1. Optional features of this aspect are set out in claims 2 to 16.

According to a second aspect of the invention there is provided a method of making an organic light emitting display device as set out in claim 16. Optional features of this aspect are set out in claims 17 to 19.

Still another aspect of the present invention provides an organic light emitting display including a bezel which can effectively protect a side surface of a display panel from an impact.

Yet another aspect of the present invention provides an organic light emitting display including a bezel which can effectively protect the lower surface of a display panel from an impact.

A further aspect of the present invention provides an organic light emitting display comprising: a display panel including a first substrate in which an organic light emitting device is formed, a second substrate opposed to the first substrate, and an encapsulation material formed between the first substrate and the second substrate; a bezel including a lower surface and a plurality of side walls extending from the edges of the lower surface, the lower surface and the side walls defining a space in which the display panel is accommodated; and a mold frame interposed between the side walls of the bezel and the display panel.

### BRIEF DESCRIPTION OF THE DRAWINGS

These and other aspects and advantages of the invention will become apparent and more readily appreciated from the following description of embodiments, taken in conjunction with the accompanying drawings of which:

FIG. 1 is an exploded perspective view for explaining an organic light emitting display according to the present invention;

FIG. 2 is a perspective view for explaining a bezel according to an embodiment of the present invention;

FIG. 3 is a cross-sectional view taken along line A1-A2 of FIG. 2;

FIG. 4 is a perspective view for explaining a bezel according to an embodiment of the present invention;

FIG. 5 is a cross-sectional view taken along line B1-B2 of FIG. 4;

FIG. 6 is a perspective view for explaining a bezel according to an embodiment of the present invention;

FIGs. 7a to 7f are partial cross-sectional views for explaining a bezel of a dual wall structure; and

FIGs. 8a to 8c are graphs showing stress measurement results through fall simulations.

### DETAILED DESCRIPTION OF EMBODIMENTS

Hereinafter, various embodiments of the present invention will be described with reference to the accompanying drawings. The embodiments are provided so that those skilled in the art can sufficiently understand aspects of the present invention, but the embodiments may be modified in various forms which fall within the scope of the present invention.

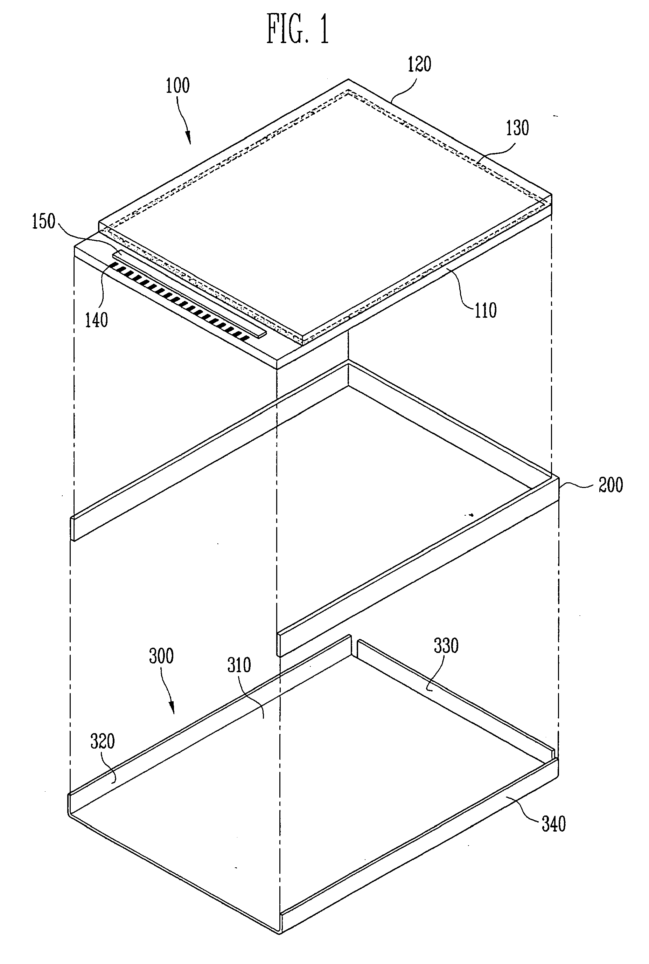

FIG. 1 is an exploded perspective view for explaining an organic light emitting display according to an embodiment of the present invention. The organic light emitting display includes a display panel 100, a bezel or support frame 300 accommodating the display panel 100, and a mold frame or intervening frame 200 interposed between the bezel 300 and the display panel 100.

The display panel 100 includes a support substrate 110 in which an organic light emitting device or an array of organic light emitting pixels is formed, an encapsulating substrate 120 opposed to the support substrate 110, and an encapsulation material 130 formed between the support substrate 110 and the encapsulating substrate 120. The support substrate 110 includes a pixel area and a non-pixel area. In the pixel area, the array connected to a scan line and a data line is formed in the form of a matrix to constitute pixels. In the non-pixel area, a scan line and a data line which extend from the scan line and the data line of the pixel area, a power source voltage supply line for the operation of the organic light emitting device, and a drive unit 150 for processing signals provided through a pad section 140 from outside and supplying the signals to the scan line and the data line are provided. An FPC (flexible printed circuit) (not shown) is connected to the pad section 140 and signals (a power source voltage, a scan signal, a data signal, etc.) are input through the FPC from outside.

In certain embodiments, the organic light emitting device or the array includes an anode electrode and a cathode electrode and an organic thin film layer formed between the anode electrode and the cathode electrode. The organic thin film layer has a structure in which a hole transport layer, an organic light emitting layer, and an electron transportation layer are stacked and can further include a hole injection layer and an electron injection layer. In addition, the organic light emitting device can further include a switching transistor for controlling the operation of the organic light emitting device and a capacitor for maintaining signals.

The encapsulating substrate 120 is formed of a transparent material such as glass and is opposed to the support substrate 110 to encapsulate the organic light emitting device. The encapsulation material is provided to prevent penetration of oxygen or moisture by encapsulating the organic light emitting device and is formed between the support substrate 110 and the encapsulating substrate 120 so as to surround the organic light emitting device. The support substrate 110 and the encapsulating substrate 120 are interconnected by the encapsulation material 130. The encapsulation material 130 may be formed of an inorganic encapsulation material or an organic encapsulation material such as a frit including at least one kind of transition metal dopant.

The bezel or support frame 300 includes a lower surface 310 and three side walls 320, 330, and 340 extending from the edges of the lower surface or plate 310. An accommodation space is formed by the lower surface 310 and the three side walls 320, 330, and 340 and the display panel 100 is accommodated so that the support substrate 110 opposes the lower surface 310 and a side surface of the display panel 100 opposes the side walls 320, 330, and 340. Then, the support substrate 110 can be attached to the lower surface 310 by a bonding tape or an adhesive. The bezel 300 can be manufactured by bending a metal plate or by extruding a plastic etc. The side walls 320, 330, and 340 may be connected to each other to be integrally formed or may be separated from each other and then assembled for the manufacturing convenience.

The mold frame or intervening frame 200 is interposed between the side walls 320, 330, and 340 of the bezel 300 and the display panel 100 and, in certain embodiments, can be formed of a plastic, an LCP, an ABS, a PCABS, a PC, or the like which may have a high impact absorbing rate. For example, the mold frame 200 can be manufactured so as to have a U-shape corresponding to the three side walls 320, 330, and 340 of the bezel 300 and can have a rectangular or circular cross-section. Further, the bezel 300 and the mold frame 200 can be integrally manufactured by using an insert molding method.

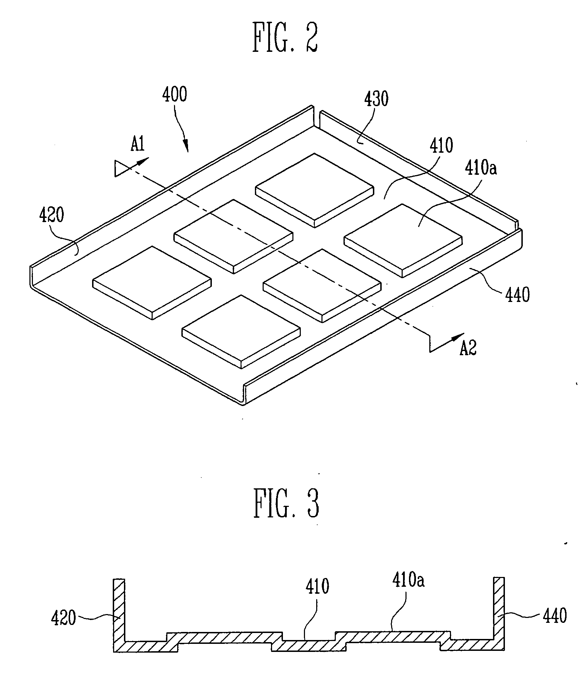

FIG. 2 is a perspective view for showing a bezel according to an embodiment of the present invention. Hereinafter, the bezel according to the embodiment of the present invention will be explained with reference to FIGs. 2 and 3. The lower surface 310 of the bezel of FIG. 1 includes a plane. However, the bezel according to the embodiment of FIGs. 2 and 3 provides a structure which can effectively absorb an impact applied to the lower surface. The bezel 400 according to the embodiment of the present invention includes a lower surface 410 and three side walls 420, 430, and 440 extending from the edges of the lower surface and rectangular protrusions 410a are formed in the lower surface 410 at predetermined intervals.

In the illustrated embodiment, a side wall is not formed along one edge of the lower plate of the bezel so that an FPC can be easily provided in the pad section 140, but in other embodiments, the bezel can include four side walls. Further, in certain embodiments, the protrusions 410a can have a circular shape as well as a rectangular shape. The pad section 140 is located in the side in which a side wall is not formed, and the display panel 100 is accommodated so that the rest of the side surfaces oppose the side walls 420, 430, and 440 and the support substrate 110 opposes the protrusions 410a.

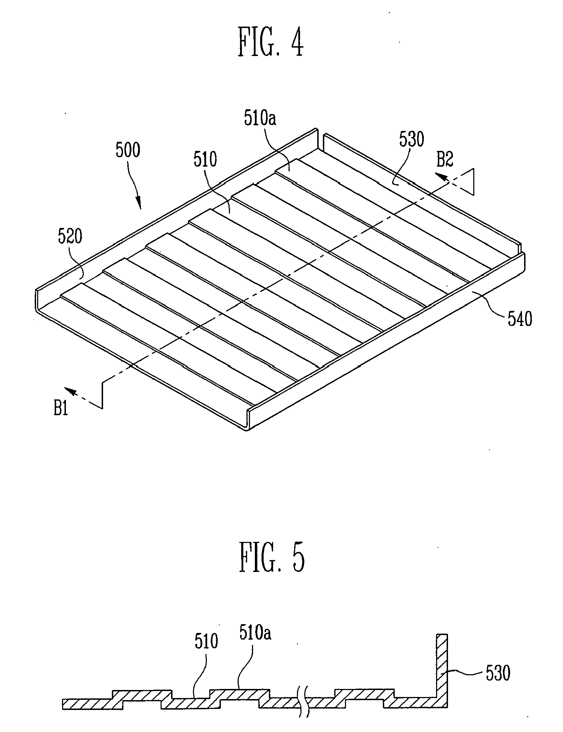

FIG. 4 is a perspective view for explaining a bezel according to another embodiment of the present invention. Hereinafter, the bezel of this embodiment will be described with reference to FIGs. 4 and 5. The bezel according to this embodiment of the present invention includes a lower surface 510 and three side walls 520, 530, and 540. As shown in FIG. 5, protrusions 510a are formed in the lower surface 510 at predetermined intervals. Each of the protrusions 510a has the form of a stripe having a predetermined width. In the illustrated embodiment, a side wall is not formed along one surface edge of the bezel so that an FPC can be easily provided in the pad section 140, but, in other embodiments the bezel can include four side walls. In certain embodiments, the protrusion 510a is shown so as to have a U-shaped cross-section but can have a curved surface. The pad section 140 is located in the side in which a side wall is not formed, and the display panel 100 is accommodated so that the rest of the side surfaces oppose the side walls 520, 530, and 540 and the support substrate 110 opposes the protrusions 510a.

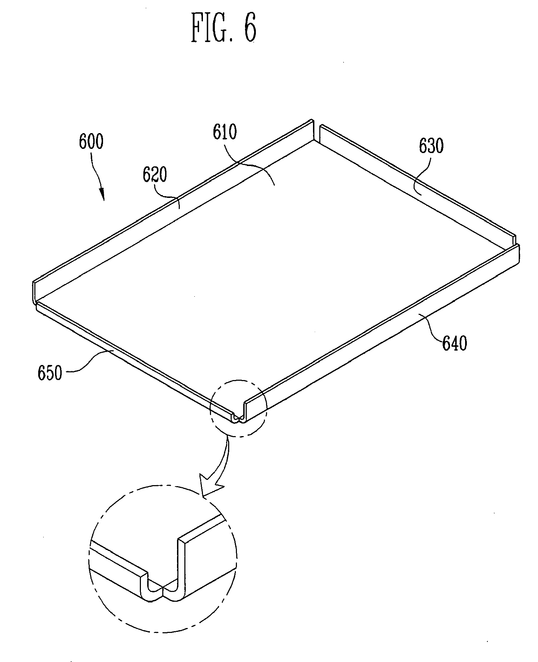

FIG. 6 is a perspective view for explaining a bezel according to a further embodiment of the present invention. The bezel according to this embodiment includes a lower surface 610 and four side walls 620, 630, 640, and 650 extending from the edges of the lower surface 610. In the bezel according to this embodiment of the present invention, one side wall 650 is formed in the front surface corresponding to one side surface of the display panel 100 and the height of the side wall 650 is equal to that of the support substrate 110 so that the FPC can be easily provided in the pad section 140 and all side surfaces of the display panel 100 can be protected.

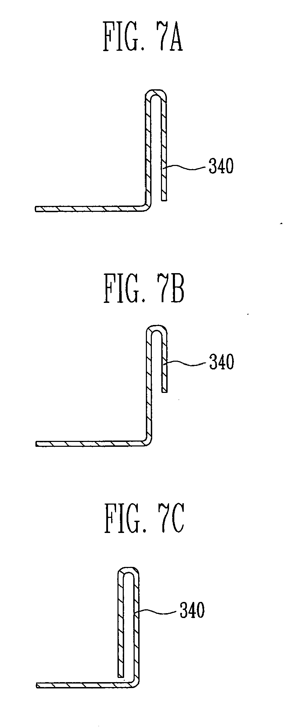

In the above-discussed embodiments, the bezels 300, 400, 500, and 600 shown in FIGs. 1, 2, 4, and 6 have sidewalls of a single wall structure. However, in certain embodiments of the present invention, side walls may be formed to have a multiple wall structure so as to provide a structure which can effectively absorb an impact applied to the side walls. FIGs. 7a to 7f show embodiments of side walls having dual wall structure using the side wall 340 of FIG. 1 as an example.

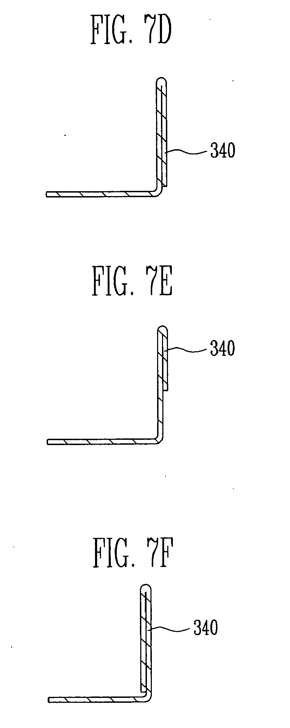

The side wall of the dual wall structure can be realized by bending the side wall 340. As shown in FIGs. 7a to 7c, the side wall 340 can be bent so that a space is formed between the walls, or as shown in FIGs. 7d to 7f, the side wall 340 can be bent so that the walls contact each other. Also, the side wall 340 can be bent inwardly or outwardly. Further, the heights of the inner and outer walls can be identical with each other as in FIGs. 7a, 7c, 7d, and 7f, or can be different from each other as in FIGs. 7b and 7e.

Table 1 shows a simulation result which has measured the maximum impact transferred to portions of the display panel in a 1 meter drop test. The table shows the results of case B using a bezel according to an embodiment of the present invention including a mold frame and a bezel in which protrusions are formed on the lower surface and the results of case A of using a conventional bezel. In the result, in the case of the inorganic encapsulation material 130, the effect is decreased by about 25 percent and in the case of the encapsulating substrate 120, the effect is decreased by about 16.3 percent. Although in the case of the edge of the support substrate 110, the stress is increased by 2.66 percent, since the absolute value of the stress is very small as compared with the encapsulating substrate 120, the influence thereof can be ignored. Then, the reasons for observing the stresses generated at the edges of the substrates 110 and 120 are as follows.

In the case of a glass substrate, many micro-cracks may be generated on a cut surface in the process of cutting the substrate into a predetermined size. Therefore, if the stress is concentrated at the crack portions, the cracks may be easily transferred to the inner side by small stresses as compared with a portion in which a crack is not generated, and thus, the substrate may be easily damaged. Therefore, it is important to observe the stresses generated at the edges of the substrates 110 and 120.

**Table 1**

| | Maximum main stress (MPa) | | Effect |
|---|---|---|---|
| | A | B | |
| Inorganic encapsulation material | 207.6 | 155.71 | Decreased by 24.98 percent |
| Edge of encapsulating substrate | 147.6 | 123.53 | Decreased by 16.29 percent |
| Edge of support substrate | 77.82 | 79.89 | Increased by 2.66 percent |

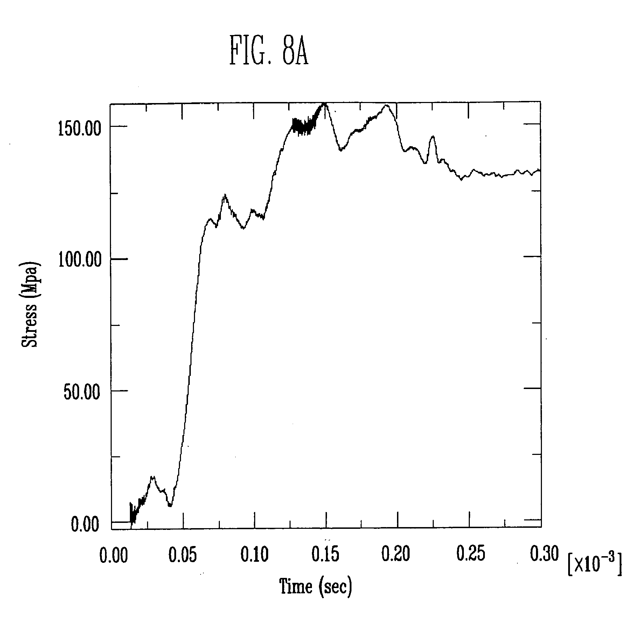

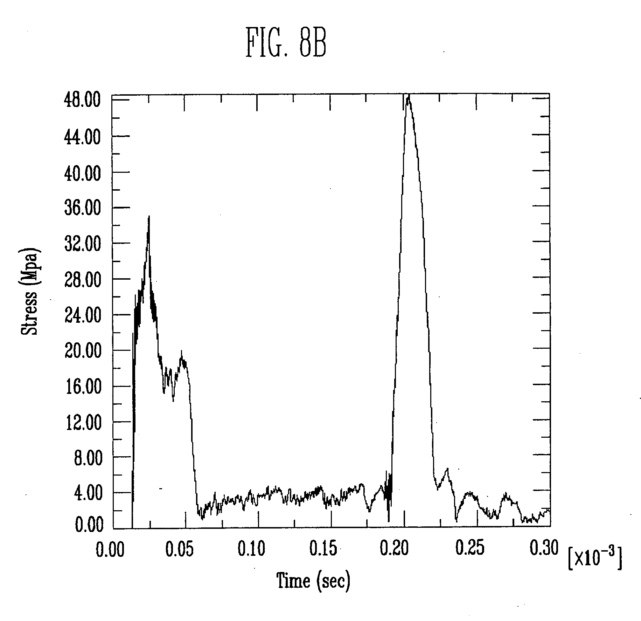

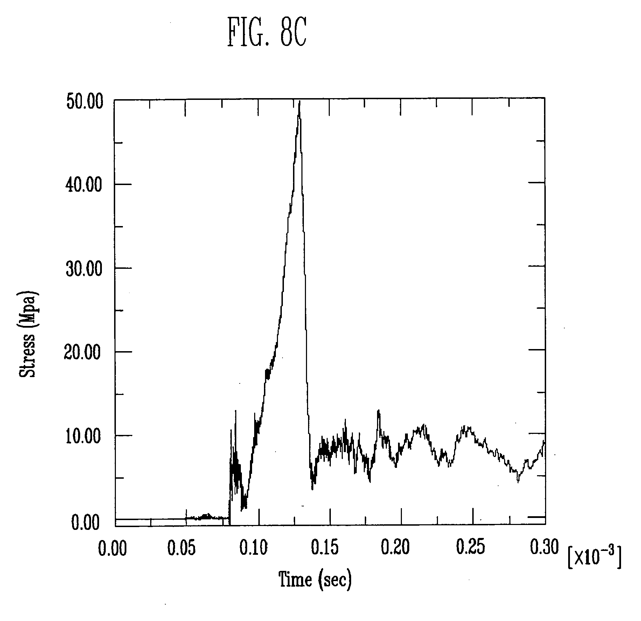

Further, FIG. 8a is a simulation result measuring stresses generated at a pad section in the case in which the conventional bezel falls toward the pad section. FIG. 8b is a simulation result measuring stresses generated at a pad section in the case in which the bezel having four side walls according to an embodiment of the present invention falls toward the pad section. FIG. 8c is a simulation result measuring stresses generated at a pad section in the case in which the bezel having three side walls according to an embodiment of the present invention falls toward the pad section.

The maximum stress transferred to the substrate in the case of the conventional bezel has the maximum value of 158.7 MPa (FIG. 8a), and those in the case of the bezels according to an embodiment of the present invention have the maximum values of 48.55 MPa (FIG. 8b) and 49.79 MPa (FIG. 8c), which are decreased by 69.4 percent and 68.6 percent as compared with the conventional bezel.

As mentioned above, according to embodiments of the present invention, an impact is absorbed by the mold frame interposed between the side wall of the bezel and the display panel and the protrusions formed on the lower surface of the bezel, effectively decreasing the stress transferred to the display panel. According to embodiments of the present invention, the stress transferred to the side surface and the lower surface can be decreased, thereby safely protecting the display panel from an impact.

As mentioned above, various embodiments of the present invention are disclosed through the descriptions and the drawings. It will be appreciated by those skilled in the art that changes might be made in the embodiments without departing from the principles of the invention, the scope of which is defined in the claims and their equivalents.

## Claims

1. An organic light emitting display device comprising:
a display panel comprising a first substrate, a second substrate opposing the first substrate, an array of organic light emitting pixels interposed between the first and second substrates, and an encapsulation material surrounding the array and interconnecting the first substrate and the second substrate, wherein the display panel comprises a first side;
a support frame comprising a lower surface and a plurality of side walls extending from edges of the lower surface, the lower surface and the plurality of side walls defining a space in which the display panel is accommodated such that a first side wall opposes the first side of the display panel, wherein the plurality of side walls comprises a first side wall opposing the first side of the display panel, wherein the first side wall comprises a first wall portion, a second wall portion and a connecting portion interconnecting the first and second wall portions, and wherein the first wall portion is interposed between the second wall portion and the first side of the display panel; and
an intervening frame comprising a first intervening portion interposed between the first side wall and the first side of the display panel.

2. A device according to Claim 1, wherein the first intervening portion contacts both the first side wall and the first side of the display panel.

3. A device according to any preceding Claim, wherein the intervening frame is bonded to the support frame.

4. A device according to any preceding Claim, wherein the display panel further comprises a second side, wherein the plurality of side walls of the support frame further comprises a second side wall, and wherein the intervening frame further comprises a second intervening portion which is interposed between the second side of the display panel and the second side wall of the support frame.

5. A device according to Claim 4, wherein the display panel further comprises a third side, wherein the plurality of side walls of the support frame further comprises a third side wall, and wherein the intervening frame further comprises a third intervening portion which is interposed between the third side of the display panel and the third side wall of the support frame.

6. A device according to Claim 5, wherein the first intervening portion has one end connected to the second intervening portion and another end connected to the third intervening portion.

7. A device according to Claim 1, wherein at least a portion of the first wall portion contacts the second wall portion.

8. A device according to Claim 1, wherein the first wall portion does not contact the second wall portion.

9. A device according to any of Claims 1, 7 or 8, wherein the first wall portion is directly connected to the lower surface and the second wall portion is positioned adjacent the side of the first wall portion nearest the lower surface.

10. A device according to any of Claims 1, 7 or 8, wherein the first wall portion is directly connected to the lower surface and the second wall portion is positioned adjacent the side of the first wall portion furthest from the lower surface.

11. A device according to any preceding Claim, wherein the intervening frame comprises a material selected from the group consisting of LCP, ABS, PCABS and PC.

12. A device according to any preceding Claim, wherein the support frame comprises a material selected from the group consisting of metal and polymeric resin.

13. A device according to any preceding Claim, wherein the encapsulation material comprises a frit.

14. A device according to Claim 13, wherein the first intervening portion of the intervening frame contacts the frit.

15. A device according to any preceding Claim, wherein the display panel comprises a surface opposing the lower surface, and wherein the surface is bonded to the lower surface.

16. A method of making an organic light emitting display device, the method comprising:
providing a support frame, wherein the support frame comprises a lower surface and a plurality of side walls extending from edges of the lower surface, the lower surface and the plurality of side walls defining a space for accommodating a display panel, wherein the plurality of side walls comprises a first side wall opposing the first side of the display panel, and wherein the first side wall comprises a first wall portion, a second wall portion and a connecting portion interconnecting the first and second wall portions;
arranging a display panel so as to be accommodated in the space of the support frame, wherein the display panel comprises a first substrate, a second substrate opposing the first substrate, an array of organic light emitting pixels interposed between the first and second substrates, and an encapsulation material surrounding the array and interconnecting the first substrate and the second substrate, and wherein the display panel comprises a first side and the display panel is accommodated such that a first side wall of the support frame opposes the first side of the display panel; and
interposing an intervening frame having a first intervening portion between the display panel and the plurality of side walls such that the first intervening portion is interposed between the first side wall and the first side of the display panel.

17. A method according to Claim 16, wherein the step of interposing an intervening frame comprises forming the intervening frame on at least one of the plurality of the side walls.

18. A method according to Claim 16, wherein the forming of the intervening frame comprises placing a curable material on the at least one of the plurality of side walls and curing the curable material.

19. A method according to any of Claims 16 to 18, wherein the intervening frame comprises a portion which contacts both the first side of the display panel and the first side wall.
